# EUROPEAN PATENT APPLICATION

(11) **EP 4 561 282 A1**
(43) Date of publication of application: **28.05.2025**
(21) Application number: 24214111.7
(22) Date of filing: 20.11.2024
(51) Int. Cl.: H05K 7/20

(54) **LIQUID PUMP UNIT**

(30) Priority: 24.11.2023 TW 112212811 U
(71) Applicant: Cooler Master Co., Ltd., Taipei City 114065 (TW)
(72) Inventor: CHEN, YI-CHENG, Taipei CIty (TW); HAUNG, YU-LUN, Taipei City (TW)
(74) Representative: Grünecker Patent- und Rechtsanwälte PartG mbB

(57) **Abstract**

A liquid pump unit may include a chassis, pump assembly, and filter device. A front panel, bottom panel, and back panel of the chassis define an interior space therewithin. The liquid pump unit may include a pump assembly including a pump, pump pipe system, and liquid connector system. The pump pipe system is fluidly coupled to the pump at a first end and fluidly coupled to the liquid connector system at a second end. The pump and the pump pipe system are disposed in the interior space. The liquid connector system is coupled to the back panel and enabled for a cooling fluid to flow therethrough. The filter device is fluidly coupled between the pump pipe system and liquid connector system and enabled to mechanically remove solid particles from the cooling fluid flowing through the liquid pump unit. The liquid pump unit and the liquid connector system are vertically disposed.

## Description

### TECHNICAL FIELD

The present disclosure relates to electronics cooling systems, and more particularly to liquid pump units for liquid cooling systems.

### BACKGROUND OF THE INVENTION

Liquid cooling systems are used in electronic systems in industries such as computing, data center, electric vehicle (EV) fast charging, telecom, laser, and medical equipment for thermal management. In data centers, in addition to air cooling, two types of liquid cooling techniques are used for servers, cold plate cooling (or direct-to-chip cooling (DTC) or direct liquid cooling (DLC)) and immersion cooling.

Cold plate cooling involves mounting of a cold plate directly on top of heat sources such as CPUs and GPUs or integrated circuit components. A working fluid inside of a cold plate chamber absorbs and transfers heat away from integrated circuit components. Immersion cooling submerges the integrated circuit components in a dielectric immersion fluid, allowing for heat dissipation into the immersion fluid via direct contact.

Coolant (or cooling) distribution units (CDUs) circulate and pump coolant in closed-loop systems within a rack and server chassis for cold plate cooling or tank for immersion cooling, called CDU loops or technology cooling systems (TCSs). Liquid-to-liquid CDUs transfer heat via a heat exchanger within the CDU and the CDU loop exchanges heat between the CDU loop and a building's facility cooling system or facilities water system (FWS). Liquid-to-air CDUs transfer heat to the ambient via a heat exchanger within the CDU.

To meet increasing heat dissipation requirements, liquid filtration devices have been integrated with CDUs to remove contaminants and particles from the CDU loop, thereby maintaining optimal performance of heat exchangers and preventing blockages that could lead to overheating and equipment failure. Nonetheless, with the liquid filtration devices being added to existing CDUs, additional space is required for installation. With CDUs and server chassis being arranged at closer and closer proximities, arranging additional space for installation of the liquid filtration devices is a challenge. Moreover, should liquid filtration devices be installed at a rack, often, maintenance or replacement of filters of the liquid filtration devices require the entire liquid filtration device to be detached from the rack, and in some cases, the CDU and the liquid filtration device are detached together. Thus, exacerbating maintenance and replacement.

### SUMMARY OF THE INVENTION

The present disclosure provides a liquid pump unit that can remove contaminants, and can be quickly and effectively maintained.

The invention is as defined in the appended claims. The techniques described herein relate to a liquid pump unit, including a chassis, a pump assembly, and filter device. The chassis includes a front panel, a bottom panel, a back panel, a chassis height, and a chassis width. The bottom panel includes a front side edge and a back side edge. The front panel is perpendicularly extended from the front side edge and the back panel is perpendicularly extended from the back side edge. The front panel, the bottom panel, and the back panel define an interior space therewithin. The chassis height is a height of the chassis and defines a vertical position of the chassis. The chassis width is a width of the chassis. The chassis height is greater than the chassis width. The pump assembly includes a pump, a pump pipe system, and a liquid connector system. The pump pipe system is fluidly coupled to the pump at a first end and fluidly coupled to the liquid connector system at a second end opposite the first end. The pump and the pump pipe system are disposed in the interior space. The liquid connector system is coupled to the back panel and enabled for a cooling fluid to flow therethrough. The filter device is fluidly coupled between the pump pipe system and the liquid connector system. The filter device is enabled to mechanically remove solid particles from the cooling fluid flowing through the liquid pump unit. The liquid pump unit and the liquid connector system are vertically disposed.

In some aspects, the techniques described herein relate to a liquid pump unit, wherein the liquid connector system includes an inlet connector and an outlet connector. The inlet connector and the outlet connector are vertically disposed and the inlet connector is disposed between the outlet connector and the back side edge.

In some aspects, the techniques described herein relate to a liquid pump unit, wherein the pump pipe system includes an inlet pipe and an outlet pipe, and wherein the pump includes a pump inlet and a pump outlet. The inlet pipe is fluidly coupled to the filter device at a lower pipe inlet end and fluidly coupled to the pump inlet at a lower pipe outlet end. The outlet pipe is fluidly coupled to the pump outlet at an upper pipe inlet end and fluidly coupled to the outlet connector at an upper pipe outlet end. In some aspects, the techniques described herein relate to a liquid pump unit, wherein the filter device includes an inlet end, a body, a liquid filter, and an outlet end. The liquid filter is removably coupled in the body and the body is respectively coupled between the outlet end and the inlet end. The filter device is fluidly coupled to the inlet connector at the inlet end and fluidly coupled to the inlet pipe at the outlet end. In some aspects, the techniques described herein relate to a liquid pump unit, the liquid pump unit further includes a check valve and the check valve is fluidly coupled between the outlet pipe and the outlet connector and enabled to prevent backflow of the cooling fluid back through the outlet pipe.

In some aspects, the techniques described herein relate to a liquid pump unit, wherein the pump pipe system includes an inlet pipe and an outlet pipe, and wherein the pump includes a pump inlet and a pump outlet. The outlet pipe is fluidly coupled to the pump outlet at an upper pipe inlet end and fluidly coupled to the filter device at an upper pipe outlet end. The inlet pipe is fluidly coupled to the inlet connector at a lower pipe inlet end and fluidly coupled to the pump inlet at a lower pipe outlet end. In some aspects, the techniques described herein relate to a liquid pump unit, wherein the filter device includes an inlet end, a body, a liquid filter, and an outlet end. The liquid filter removably coupled in the body and the body is respectively coupled between the outlet end and the inlet end. The filter device is fluidly coupled to the outlet pipe at the outlet end and fluidly coupled to the outlet connector at the inlet end. In some aspects, the techniques described herein relate to a liquid pump unit, further including a check valve and check valve is fluidly coupled between the inlet pipe and the inlet connector and enabled to prevent backflow of the cooling fluid back through the inlet connector.

In some aspects, the techniques described herein relate to a liquid pump unit, further including a cover panel, a handle, and a plurality of mounting components, the cover panel removably coupled to the front panel, the bottom panel, and the back panel, the cover panel further defining the interior space, the handle coupled to the front panel, the plurality of mounting components coupled to the back panel and enabled for fastening of the liquid pump unit. In some aspects, the techniques described herein relate to a liquid pump unit, further including a liquid pump driver and an electrical connector. The electrical connector is coupled to the back panel and the liquid pump driver is coupled to the cover panel. The liquid pump driver is electrically coupled to the pump and the electrical connector to drive the pump to transport the cooling fluid through the liquid pump unit.

In some aspects, the techniques described herein relate to a liquid pump unit, further including a support plate base and an access panel, and wherein the bottom panel further includes a panel opening. The support plate base is coupled to the bottom panel at a bottom plate side and coupled to the pump at an upper plate side. The support plate base is between the front side edge and the panel opening. The panel opening is between the support plate base and the back side edge. The access panel is removably coupled to the panel opening.

In some aspects, the techniques described herein relate to a liquid pump unit, wherein the filter device is a Y-strainer and the Y-strainer is horizontally disposed.

### BRIEF DESCRIPTION OF DRAWINGS

Unless specified otherwise, the accompanying drawings illustrate aspects of the innovative subject matter described herein. Referring to the drawings, wherein like reference numerals indicate similar parts throughout the several views, several examples of liquid pump units incorporating aspects of the presently disclosed principles are illustrated by way of example, and not by way of limitation.
Fig. 1 illustrates a perspective view of a liquid pump unit, in accordance with various embodiments of the present disclosure.
Fig. 2A illustrates an internal perspective view of the liquid pump unit of Fig. 1, in accordance with various embodiments of the present disclosure.
Fig. 2B illustrates another internal perspective view of the liquid pump unit of Fig. 1, in accordance with various embodiments of the present disclosure.
Fig. 3 illustrates a cross-section view of the liquid pump unit of Fig. 1, in accordance with various embodiments of the present disclosure.
Fig. 4 illustrates a cross-section view of an alternative liquid pump unit, in accordance with various embodiments of the present disclosure.

### DETAILED DESCRIPTION

The following describes various principles related to components and assemblies for electronic devices cooling by way of reference to specific examples of liquid pump units, including specific arrangements and examples of chassis, and pumps embodying innovative concepts. More particularly, but not exclusively, such innovative principles are described in relation to selected examples of pipes, Y-Strainers, and access paneling and well-known functions or constructions are not described in detail for purposes of succinctness and clarity. Nonetheless, one or more of the disclosed principles can be incorporated in various other embodiments of pipes, Y-Strainers, and access paneling to achieve any of a variety of desired outcomes, characteristics, and/or performance criteria.

Thus, pipes, Y-Strainers, and access paneling having attributes that are different from those specific examples discussed herein can embody one or more of the innovative principles, and can be used in applications not described herein in detail. Accordingly, embodiments of pipes, Y-Strainers, and access paneling not described herein in detail also fall within the scope of this disclosure, as will be appreciated by those of ordinary skill in the relevant art following a review of this disclosure.

Example embodiments as disclosed herein are directed to liquid pump units that can be used in coolant (or cooling) distribution units (CDUs) or as reservoir and pumping units (RPUs) of cooling systems to dissipate high heat loads. The CDUs or RPUs may be configured at a rack and server chassis, or as part of a cooling system that includes heat producing electronic components to be cooled. The liquid pump units can be hot-swappable within the cooling system, allowing for removal and/or maintenance without downtime of the cooling system. The cooling system includes at least one liquid pump unit comprising one or more liquid-based cooling loops. The liquid pump unit may be coupled to the rack and server chassis via fasteners (e.g., bolts, screws, etc.). The liquid pump unit may also be coupled to a water tank, as an example, transporting coolant to heat producing electronic components to be cooled.

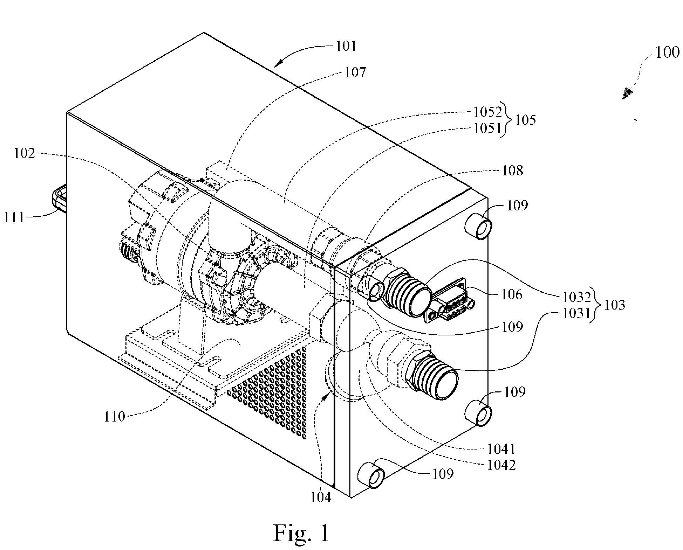

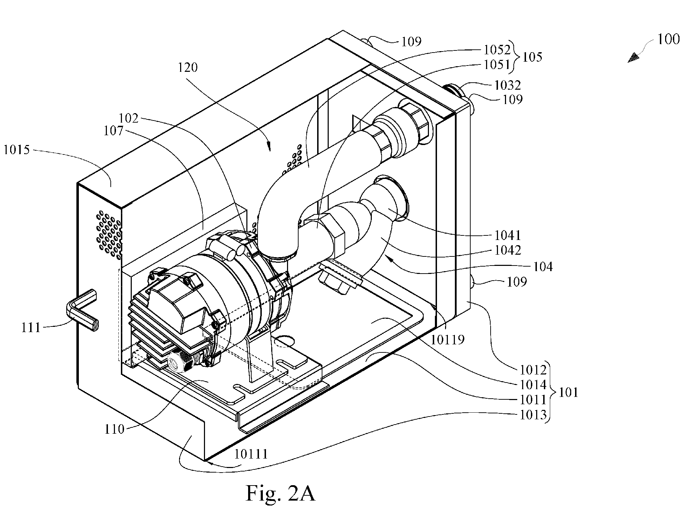

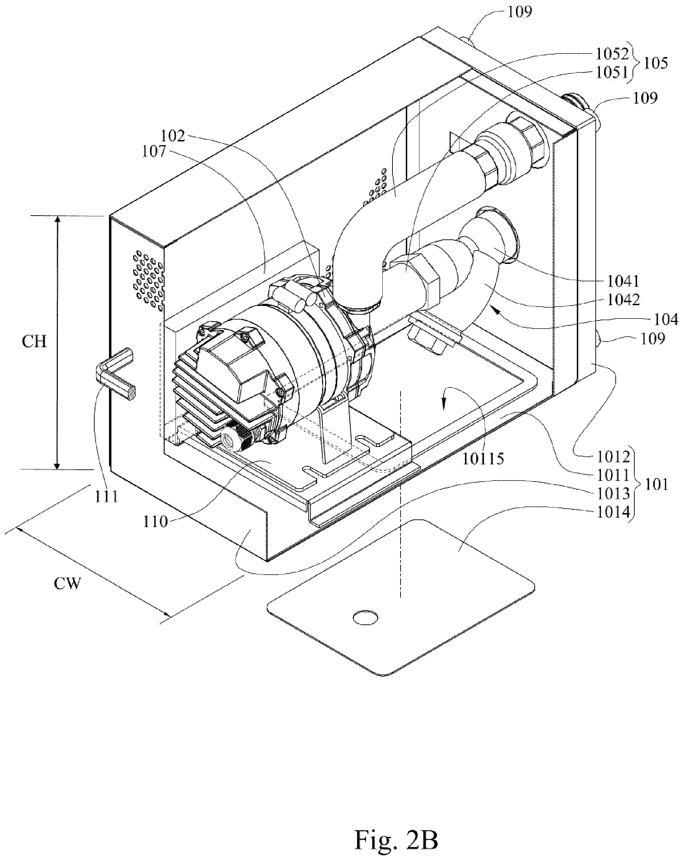

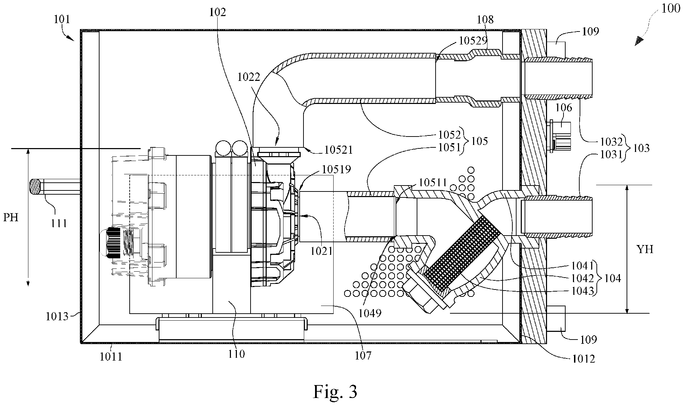

Figs. 1, 2A, 2B, and 3 illustrate a liquid pump unit 100 in accordance with various embodiments of the present disclosure. The liquid pump unit 100 includes a chassis 101, a pump assembly 102, 105, 103, and a filter device 104. The chassis 101 includes a front panel 1013, a bottom panel 1011, a back panel 1012, a chassis height CH, and a chassis width CW. The bottom panel 1011 includes a front side edge 10111 and a back side edge 10119. The front panel 1013 is perpendicularly extended from the front side edge 10111 and the back panel 1012 is perpendicularly extended from the back side edge 10119. The front panel 1013, the bottom panel 1011, and the back panel 1012 define an interior space 120 therewithin. The chassis height CH is a height of the chassis 101 and defines a vertical position of the chassis 101. The chassis width CW is a width of the chassis 101. The chassis height CH is greater than the chassis width CW. The pump assembly 102, 105, 103 includes a pump 102, a pump pipe system 105, and a liquid connector system 103. The pump pipe system 105 is fluidly coupled to the pump 102 at a first end 10519, 10521 and fluidly coupled to the liquid connector system 103 at a second end 10511, 10529 opposite the first end 10519, 10521. The pump 102 and the pump pipe system 105 are disposed in the interior space 120. The liquid connector system 103 is coupled to the back panel 1012 and enabled for a cooling fluid to flow therethrough. The filter device 104 is fluidly coupled between the pump pipe system 105 and the liquid connector system 103. The filter device 104 is enabled to mechanically remove solid particles from the cooling fluid flowing through the liquid pump unit 100. The liquid pump unit 100 and the liquid connector system 103 are vertically disposed.

In some embodiments the liquid pump unit 100 further includes a cover panel 1015, a handle 111, and a plurality of mounting components 109. The cover panel 1015 is removably coupled to the front panel 1013, the bottom panel 1011, and the back panel 1012. The cover panel 1015 further defines the interior space 120. The handle 111 is coupled to the front panel 1013. The plurality of mounting components 109 is coupled to the back panel 1012 and enabled for fastening of the liquid pump unit 100. In some embodiments, the plurality of mounting components 109 include mount bushings. In some embodiments the liquid pump unit 100 further includes a liquid pump driver 107 and an electrical connector 106. The electrical connector 106 is coupled to the back panel 1012 and the liquid pump driver 107 is coupled to the cover panel 1015. The liquid pump driver 107 is electrically coupled to the pump 102 and the electrical connector 106 to drive the pump 102 to transport the cooling fluid through the liquid pump unit 100.

In some embodiments the liquid pump unit 100 further includes a support plate base 110 and an access panel 1014, and wherein the bottom panel 1011 further includes a panel opening 10115. The support plate base 110 is coupled to the bottom panel 1011 at a bottom plate side and coupled to the pump 102 at an upper plate side. The support plate base 110 is between the front side edge 10111 and the panel opening 10115. The panel opening 10115 is between the support plate base 110 and the back side edge 10119. The access panel 1014 is removably coupled to the panel opening 10115. The support plate base 110 is enabled to provide stability for the pump 102 when operating, minimizing vibration of the liquid pump unit 100.

In some embodiments, the liquid connector system 103 includes an inlet connector 1031 and an outlet connector 1032. The inlet connector 1031 and the outlet connector 1032 are vertically disposed and the inlet connector 1031 is disposed between the outlet connector 1032 and the back side edge 10119.

In some embodiments, the pump pipe system 105 includes an inlet pipe 1051 and an outlet pipe 1052, and wherein the pump 102 includes a pump inlet 1021 and a pump outlet 1022. The inlet pipe 1051 is fluidly coupled to the filter device 104 at a lower pipe inlet end 10511 and fluidly coupled to the pump inlet 1021 at a lower pipe outlet end 10519. The outlet pipe 1052 is fluidly coupled to the pump outlet 1022 at an upper pipe inlet end 10521 and fluidly coupled to the outlet connector 1032 at an upper pipe outlet end 10529. In some embodiments, the filter device 104 includes an inlet end 1041, a body 1042, a liquid filter 1043, and an outlet end 1049. The liquid filter 1043 is removably coupled in the body 1042 and the body 1042 is respectively coupled between the outlet end 1049 and the inlet end 1041. The filter device 104 is fluidly coupled to the inlet connector 1031 at the inlet end 1041 and fluidly coupled to the inlet pipe 1051 at the outlet end 1049. In some embodiments, the liquid pump unit 100 further includes a check valve 108 and the check valve 108 is fluidly coupled between the outlet pipe 1052 and the outlet connector 1032 and enabled to prevent backflow of the cooling fluid back through the outlet pipe 1052.

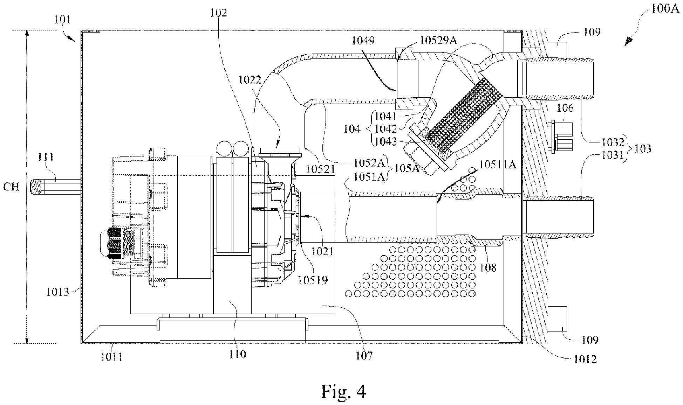

Fig. 4 illustrates an alternative liquid pump unit 100A in accordance with various embodiments of the present disclosure. The alternative liquid pump unit 100A can be similar in some respects as the liquid pump unit 100 of Figs. 1, 2A, 2B, and 3, and therefore may be best understood with reference thereto where like numerals designate like components not described again in detail. Differences between the alternative liquid pump unit 100A of Fig. 4 and the liquid pump unit 100 of Figs. 1, 2A, 2B, and 3 is that the filter device 104 can be fluidly coupled to the outlet pipe 1052A and not the inlet pipe 1051A and the check valve 108 can be fluidly coupled to the inlet pipe 1051A and not the outlet pipe 1052A.

In some embodiments, the pump pipe system 105A includes an inlet pipe 1051A and an outlet pipe 1052A, and wherein the pump 102 includes a pump inlet 1021 and a pump outlet 1022. The outlet pipe 1052A is fluidly coupled to the pump outlet 1022 at an upper pipe inlet end 10521 and fluidly coupled to the filter device 104 at an upper pipe outlet end 10529A. The inlet pipe 1051A is fluidly coupled to the inlet connector 1031 at a lower pipe inlet end 10511A and fluidly coupled to the pump inlet 1021 at a lower pipe outlet end 10519. In some embodiments, the filter device 104 includes an inlet end 1041, a body 1042, a liquid filter 1043, and an outlet end 1049. The liquid filter 1043 removably coupled in the body 1042 and the body 1042 is respectively coupled between the outlet end 1049 and the inlet end 1041. The filter device 104 is fluidly coupled to the outlet pipe 1052A at the outlet end 1049 and fluidly coupled to the outlet connector 1031 at the inlet end 1041. In some embodiments the liquid pump unit 100 further includes a check valve 108 and check valve 108 is fluidly coupled between the inlet pipe 1051A and the inlet connector 1031 and enabled to prevent backflow of the cooling fluid back through the inlet connector 1031.

In some embodiments, the filter device 104 is a Y-strainer and the Y-strainer is horizontally disposed. Y-strainers can be known to be compact for integration within critical liquid flow applications. In some embodiments, the filter device 104 includes perforated filter screens, wire mesh, or filters made of cotton material, as examples. In some embodiments, the pump 102 includes a pump height PH and the filter device 104 includes a filter height YH. The pump height PH and the filter height YH are respective vertical heights of the pump height PH and the filter device 104. The filter height YH is less than the pump height PH.

Filtration of cooling fluid, without increasing requirement for rack and server chassis space or additional exterior space, is provided by the embodiments of the liquid pump unit 100/100A. The horizontally disposed filter device 104, integrated within the vertical liquid pump unit 100/100A, combine the features of liquid pump units 100/100A, with the added functionality of liquid filtration. Cooling fluid enters the filter device 104 (as an example, Y-strainer) from the liquid connector system 103 through the inlet end 1041 and then into the body 1042. The cooling fluid flows under pressure past the liquid filter 1043, whereby the filter traps contaminants, particles, and other foreign matter that is larger than the filter openings. The filtered cooling fluid then exits the Y-strainer through the outlet end 1049 to the pump pipe system 105 before being transported to heat exchangers, also as an example. Thus, contaminants and particles are removed from liquid cooling systems, thereby maintaining optimal performance of heat exchangers and preventing blockages that could lead to overheating and equipment failure. Moreover, as Y-strainers can include removably coupled strainer caps for removing the contaminants and particles, the access panel 1014 enables a user direct access to Y-strainer and the strainer cap for maintenance. Thus, liquid pump units 100/100A that can remove contaminants and particles, and can be quickly and effectively maintained is provided.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A liquid pump unit (100, 100A), comprising:
a chassis (101) including a front panel (1013), a bottom panel (1011), a back panel (1012), a chassis height (CH), and a chassis width (CW), the bottom panel (1011) including a front side edge (10111) and a back side edge (10119), the front panel (1013) perpendicularly extends from the front side edge (10111), the back panel (1012) perpendicularly extends from the back side edge (10119), the front panel (1013), the bottom panel (1011), and the back panel (1012) define an interior space (120) therewithin, the chassis height (CH) is a height of the chassis (101) and defines a vertical position of the chassis (101), the chassis width (CW) is a width of the chassis (101), the chassis height (CH) is greater than the chassis width (CW);
a pump assembly (102, 103, 105) including a pump (102), a pump pipe system (105, 105A), and a liquid connector system (103), the pump pipe system (105, 105A) fluidly coupled to the pump (102) at a first end (10519, 10521), and the pump pipe system (105, 105A) fluidly coupled to the liquid connector system (103) at a second end (10511, 10529), the second end (10511, 10529) opposite the first end (10519, 10521), the pump (102) and the pump pipe system (105, 105A) disposed in the interior space (120), the liquid connector system (103) coupled to the back panel (1012) and enabled for a cooling fluid to flow therethrough; and
a filter device (104), the filter device (104) fluidly coupled between the pump pipe system (105, 105A) and the liquid connector system (103), the filter device (104) enabled to mechanically remove solid particles from the cooling fluid flowing through the liquid pump unit (100, 100A); and
wherein, the liquid pump unit (100, 100A) and the liquid connector system (103) are vertically disposed.

2. The liquid pump unit (100, 100A) of claim 1, wherein the liquid connector system (103) comprises an inlet connector (1031) and an outlet connector (1032), the inlet connector (1031) and the outlet connector (1032) are vertically disposed, the inlet connector (1031) disposed between the outlet connector (1032) and the back side edge (10119).

3. The liquid pump unit (100) of claim 2, wherein the pump pipe system (105) comprises an inlet pipe (1051) and an outlet pipe (1052), and wherein the pump (102) comprise a pump inlet (1021) and a pump outlet (1022), the inlet pipe (1051) fluidly coupled to the filter device (104) at a lower pipe inlet end (10511) and fluidly coupled to the pump inlet (1021) at a lower pipe outlet end (10519), the outlet pipe (1052) fluidly coupled to the pump outlet (1022) at an upper pipe inlet end (10521) and fluidly coupled to the outlet connector (1032) at an upper pipe outlet end (10529).

4. The liquid pump unit (100) of claim 3, wherein the filter device (104) comprises an inlet end (1041), a body (1042), a liquid filter (1043), and an outlet end (1049), the liquid filter (1043) removably coupled in the body (1042), the body (1042) respectively coupled between the outlet end (1049) and the inlet end (1041), the filter device (104) fluidly coupled to the inlet connector (1031) at the inlet end (1041) and fluidly coupled to the inlet pipe (1051) at the outlet end (1049).

5. The liquid pump unit (100) of claim 3 or 4, further comprising a check valve (108), the check valve (108) fluidly coupled between the outlet pipe (1052) and the outlet connector (1032), the check valve (108) enabled to prevent backflow of the cooling fluid back through the outlet pipe (1052).

6. The liquid pump unit (100A) of claim 2, wherein the pump pipe system (105A) comprises an inlet pipe (1051A) and an outlet pipe (1052A), and wherein the pump comprise a pump inlet (1021) and a pump outlet (1022), the outlet pipe (1052A) fluidly coupled to the pump outlet (1022) at an upper pipe inlet end and fluidly coupled to the filter device (104) at an upper pipe outlet end (10529A), the inlet pipe (1051A) fluidly coupled to the inlet connector (1031) at a lower pipe inlet end (10511A) and fluidly coupled to the pump inlet (1021) at a lower pipe outlet end.

7. The liquid pump unit (100A) of claim 6, wherein the filter device (104) comprises an inlet end (1041), a body (1042), a liquid filter (1043), and an outlet end (1049), the liquid filter (1043) removably coupled in the body (1042), the body (1042) respectively coupled between the outlet end (1049) and the inlet end (1041), the filter device (104) fluidly coupled to the outlet pipe (1052A) at the outlet end (1049) and fluidly coupled to the outlet connector (1032) at the inlet end (1041).

8. The liquid pump unit (100A) of claim 6 or 7, further comprising a check valve (108), the check valve (108) fluidly coupled between the inlet pipe (1051A) and the inlet connector (1031), the check valve (108) enabled to prevent backflow of the cooling fluid back through the inlet connector (1031).

9. The liquid pump unit (100, 100A) of one of claims 1 to 8, further comprising a cover panel (1015), a handle (111), and a plurality of mounting components (109), the cover panel (1015) removably coupled to the front panel (1013), the bottom panel (1011), and the back panel (1012), the cover panel (1015) further defining the interior space (120), the handle (111) coupled to the front panel (1013), the plurality of mounting components (109) coupled to the back panel (1012) and enabled for fastening of the liquid pump unit (100, 100A).

10. The liquid pump unit (100, 100A) of claim 9, further comprising a liquid pump driver (107) and an electrical connector (106), the electrical connector (106) coupled to the back panel (1012), the liquid pump driver (107) coupled to the cover panel (1015), the liquid pump driver (107) electrically coupled to the pump (102) and the electrical connector (106) to drive the pump (102) to transport the cooling fluid through the liquid pump unit (100, 100A).

11. The liquid pump unit (100, 100A) of one of claims 1 to 10, further comprising a support plate base (110) and an access panel (1014), and wherein the bottom panel (1011) further comprises a panel opening (10115), the support plate base (110) coupled to the bottom panel (1011) at a bottom plate side and coupled to the pump (102) at an upper plate side, the support plate base (110) between the front side edge (10111) and the panel opening (10115), the panel opening (10115) between the support plate base (110) and the back side edge (10119), the access panel (1014) removably coupled to the panel opening (10115).

12. The liquid pump unit (100, 100A) of one of claims 1 to 11, wherein the filter device (104) is a Y-strainer, the Y-strainer being horizontally disposed.
